# EUROPEAN PATENT APPLICATION

(11) **EP 4 408 129 A1**
(43) Date of publication of application: **31.07.2024**
(21) Application number: 23153093.2
(22) Date of filing: 24.01.2023
(51) Int. Cl.: H05K 1/02, H05K 3/34, H05K 3/00

(54) **PRINTED CIRCUIT BOARD AND METHOD OF DETERMINING THE SOLDER WETTING QUALITY OF A PRINTED CIRCUIT BOARD**

(71) Applicant: Magna Electronics Sweden AB, 447 37 Vårgårda (SE)
(72) Inventor: ROMBO, Lars, 583 30 Linköping (SE); PRYTZ, Hakan, 583 30 Linköping (SE); WISEMAN, Michael, 583 30 Linköping (SE); PAJANDER, Johannes, 583 30 Linköping (SE)
(74) Representative: Müller Verweyen

(57) **Abstract**

A printed circuit board (10) comprises a substrate (13) and circuit traces provided on the substrate (13). The printed circuit board (10) comprises a solder wetting indicator (12). The solder wetting indicator (12) comprises a solder pattern (14) arranged on the substrate (13). The solder pattern (14) comprises small solder volume deposits (15a-15f) arranged along at least one line and having varying distances from each other.

## Description

The invention relates to a printed circuit board comprising a substrate and circuit traces provided on the substrate, and a method of determining the solder wetting quality of a printed circuit board.

The solderability of printed circuit boards or PCBs is a quality issue. Process variations at the PCB supplier, shipment and storage can have a significant effect on the solderability on the plated solder pads.

The problem underlying the present invention is to provide a printed circuit board and a method enabling simple and cost-effective determination of the solder wetting quality of the printed circuit board.

The invention solves this problem with the features of the independent claims.

According to the invention, the printed circuit board comprises a solder wetting indicator, wherein the solder wetting indicator comprises a solder pattern arranged on the substrate wherein the solder pattern comprises small solder volume deposits arranged along at least one line and having varying distances from each other. The small solder volume deposits can be for example solder spots, but not limited to these. Generally, the reflowing causes the small solder volume deposits of the solder wetting indicator to run along each corresponding line of small solder volume deposits, thus reaching out and possibly fusing with, and creating solder bridges between, adjacent small solder volume deposits of the same line. This bridging behavior relates to the wetting quality of the solder, where the number of solder bridges generally correlates with the solder wetting quality. Generally, a short or bridge between adjacent small solder volume deposits means good wetting. The more shorts and coalescence in-between the solder paste, the better the reflow and solder process. Therefore, the inventive solder wetting indicator provides a simple and cost-effective possibility for determining the solder quality of every printed circuit board in production, and also the plating quality by the PCB supplier. The performance of each PCB can be documented and compared during running of production.

Preferably the solder pattern comprises small solder volume deposits arranged along a plurality of lines. Preferably the small solder volume deposits of the or each line are applied on a corresponding conductive line or pad provided on the substrate. Preferably the small solder volume deposits of some or all lines have differently varying distances from each other as compared to the small solder volume deposits of some or all other lines of small solder volume deposits. Preferably the lines of small solder volume deposits are arranged parallel to each other. The number of lines with small solder volume deposits in the solder wetting indicator generally can be any integer number equal to or greater than one, where the most preferred number of lines of small solder volume deposits is four, as an optimal compromise between precision and space requirements of the solder wetting indicator. Preferably, the small solder volume deposits in a line are arranged at least partly with monotonically increasing or decreasing, preferably logarithmically varying, distances. The solder wetting indicator can be customized with different solder paste patterns based on surface finish (Tin, Silver, Gold) offered by the PCB fabricator.

At least one solder wetting indicator is preferably provided on both sides of the printed circuit board. In an embodiment of the invention, the solder wetting indicator is arranged in a margin region and/or a waste area of the printed circuit board. In this case, after the end product PCBs have been cut out of the printed circuit board, the solder wetting indicator is waste and can be disposed of. Alternatively, at least one solder wetting indicator can be arranged on every end product PCB. This has an advantage of traceability, because the individual quality of the soldering at the production can be attested over the lifetime of every end product PCB.

The inventive solder wetting indicator allows for a simple visual detection of poor solder wetting quality cause by one or more of: the PCB being out of date; solder oven temperature profile issues; inferior PCB quality; solder paste issues; incorrect transport and storage conditions or shelf-life of the PCB and/or the solder paste, etc. Rapid detection of suspicious materials is possible. Furthermore, a comparison of the primary side vs. the secondary side process results is possible through the inventive solder wetting indicator. In addition to the PCB quality, the solder wetting indicator also reveals the solder paste performance and the surface mount technology (SMT) process setup. Also possible is a comparison of PCBs from different sources or alternative PCB suppliers. The solder wetting indicator can be used to evaluate and benchmark new solder paste chemistries with respect to flux performance, which is a key factor for soldering.

In a preferred embodiment, the solder wetting indicator comprises an offset indication pattern arranged in a positional relationship to the (primary) solder pattern and indicating the set positions of the small solder volume deposits on the substrate before reflow. For better visibility, the offset indication pattern itself is preferably free of solder deposit. Preferably, the offset indication pattern comprises one or more offset indication lines, wherein the or each offset indication line is arranged in parallel to a corresponding line of small solder volume deposits. In other words, each offset indication line corresponds to, and is arranged next to, a line of small solder volume deposits, resulting in an alternating arrangement of small solder volume deposit lines and offset indication lines. Each offset indication line preferably comprises offset indication spots indicating the set position of the small solder volume deposits along the corresponding line of small solder volume deposits. Generally, the offset indication pattern greatly facilitates the inspection of the small solder volume deposits after curing or baking relative to their set position.

The offset indication lines thus correspond to the varying gaps between the small solder volume deposits on the (primary) wetting indicator lines, namely, the gaps between the small solder volume deposits before they are reflow soldered. The offset indication lines facilitate an inspection of what gap lengths wetted as individual solder volume deposits coalesced together.

Preferably the offset indication pattern is made of circuit traces provided on the substrate. In this case, the offset indication spots can be formed by spots of conductive traces, or by voids between conductive traces.

According to a further aspect of the invention, a method of producing a printed circuit board is provided, comprising the steps of: providing a printed circuit board with a substrate, circuit traces provided on the substrate, and a solder wetting indicator, wherein the solder wetting indicator comprises a solder pattern arranged on the substrate, wherein the solder pattern comprises small solder volume deposits arranged along at least one line and having varying distances from each other; subjecting the printed circuit board to a reflow process; counting the number of bridges between adjacent small solder volume deposits in a line by human inspection or an automatic inspection device; and determining the solder wetting quality depending on the number of bridges counted. By counting the number of solder bridges between the small solder volume deposits after reflow, a quantitative indication of the solder wetting quality is obtained. The analysis can be done by a human or with an inspection device, for example an optical inspection device.

The determination of the solder wetting quality advantageously can be used in different ways. In one embodiment, for example, machine parameters of a machine for producing printed circuit boards are adjusted depending on the determined solder wetting quality. In another embodiment, parameters of a reflow oven for heating, curing or baking printed circuit boards in the production process are adjusted depending on the determined solder wetting quality. In other words, the reflow oven profile settings can be re-adjusted based on the determined solder wetting quality, showing quantified solder results for the first side and second side reflow passes. Since the PCB properties can change from curing or baking the first side (pass 1) to curing or baking the second side (pass 2), the solder wetting indicator can look different on the two side of the printed circuit board, for example having different scales (distances between the small solder volume deposits). The solder wetting indicator can thus be used to fine tune and optimize the reflow oven settings. In this manner, the solderability can advantageously be ensured until the final pass of reflow soldering, where, generally, higher complexity, advanced electronic components are mounted and connected.

After all, the inventive solder wetting indicator can be used for volume production setup and control.

In the following the invention shall be illustrated on the basis of preferred embodiments with reference to the accompanying drawings, wherein:
- Fig. 1: shows a plane view onto a printed circuit board; and
- Figs. 2-5: show plane views on a solder wetting indicator at different times in the production process.

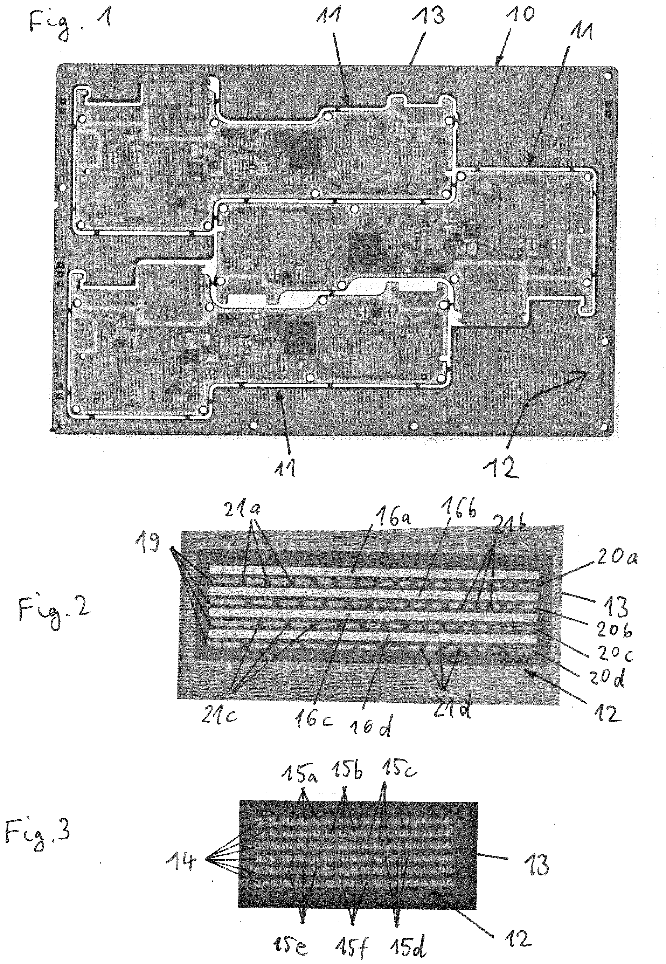

The printed circuit board 10 generally can be an end product PCB 11 or, like in Figure 1, an intermediate product comprising any number, here three, of end product PCBs 11. The printed circuit board 10 is composed of an isolating substrate 13 and conductive traces provided on one or both sides of the substrate 13, which is known per se in the art. The printed circuit board 10 comprises at least one solder wetting indicator 12, preferably a plurality of solder wetting indicators 12. Although Figure 1 shows only one solder wetting indicator 12, the printed circuit board 10 preferably comprises at least one solder wetting indicator 12 on each side of the printed circuit board 10.

The or any solder wetting indicator 12 can be arranged in a margin region and/or in a waste area of the printed circuit board 10, like in Figure 1, which is waste after the end product PCBs 11 have been cut out of the printed circuit board 10.

Alternatively, at least one solder wetting indicator 12 can be arranged on any end product PCB 11. This has an advantage of traceability, because the quality of the soldering at the production can be attested over the lifetime of the end product PCB 11.

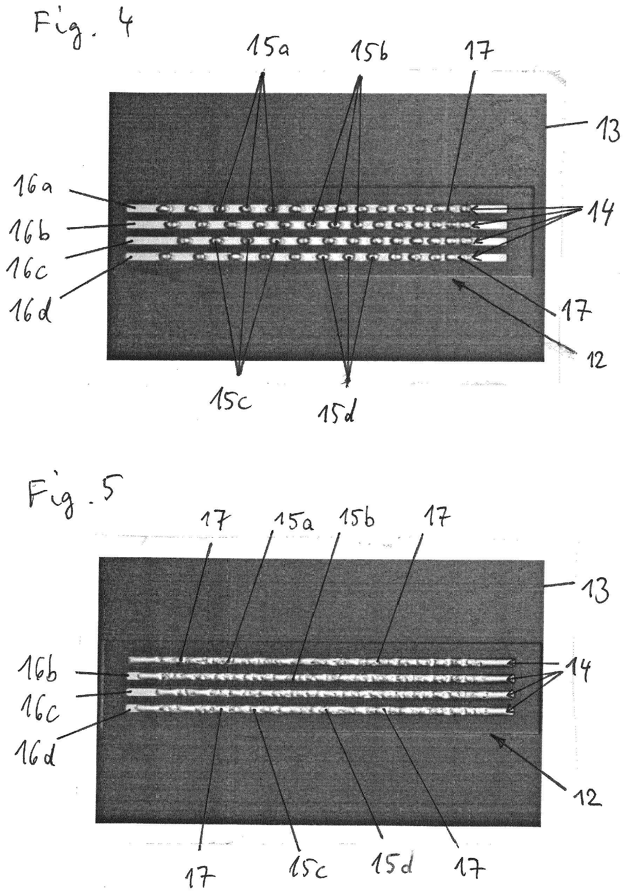

The or any solder wetting indicator 12 comprises a solder pattern 14 arranged on the substrate 13. The solder pattern 14 comprises small solder volume deposits 15a-15f arranged in one or more lines on the substrate 13. The embodiment of Figure 3 comprises small solder volume deposits 15a-15f arranged in, for example, six parallel lines, i.e., small solder volume deposits 15a arranged in a first line, small solder volume deposits 15b arranged in a second line parallel to the first line, small solder volume deposits 15c arranged in a third line parallel to the first and second line, etc. The number of lines with small solder volume deposits 15a-15e can be different from six and generally can be any integer number equal to or greater than one, where the most preferred number of lines of small solder volume deposits 15a-15d is four, as shown in Figures 4 and 5, as the optimum compromise between precision and space requirements of the solder wetting indicator 12.

The small solder volume deposits 15a-15e are preferably applied or printed on corresponding conductive lines or pads 16a-16d provided on the substrate 13, see Figure 2. The conductive lines 16a-16d are part of the conductive traces which are for example made of Copper. The conductive lines 16a-16d are preferably stripes of a certain length, preferably electrically isolated from each other, and preferably electrically isolated from all other conductive traces on the substrate 13, in order not to interfere with the electric circuitry of the printed circuit board 10.

Within each line the small solder volume deposits 15a-15f are preferably arranged with monotonically increasing or decreasing distances relative to each other. For example, in Figure 3 the small solder volume deposits 15a-15f in each line are arrange with decreasing distances from left to right. More specifically, the small solder volume deposits 15a-15f in a line can be arranged with logarithmically varying distances. The above features allow a more quantitative statement about the soldering quality, as will be explained below.

The process of generating and evaluating the at least one solder wetting indicator 12 is explained in the following on the basis of the enclosed Figures.

First of all, a printed circuit board 10 is provided in a pre-soldering condition, i.e., still without solder. In this state, the solder wetting indicator 12 may look as shown in Figure 2. In the following, it is assumed that a solder wetting indicator 12 is provided on both sides of the printed circuit board 10.

In the next step, the solder including the small solder volume deposits 15a-15f is applied to the printed circuit board 10. After this step, the solder wetting indicator 12 may look as shown in Figure 3, where the small solder volume deposits 15a-15f are precisely positioned at their set position.

Then at least one step of curing or baking, also called reflowing, is applied to the printed circuit board 10 for example in an oven. Usually, one side of the PCB is cured or baked at a time. Therefore, in the present embodiment, where a solder wetting indicator 12 is provided on both sides of the printed circuit board 10, the reflow step preferably comprises two passes, namely a first pass for curing or baking the first side of the printed circuit board 10, and a second pass for curing or baking the second side of the printed circuit board 10.

After the reflowing step, the solder wetting indicator 12 may look as shown in Figure 4 or Figure 5. Generally, the reflowing causes the small solder volume deposits 15a-15d to run along the conductive lines 16 (sideways in Figures 2-5), thus smearing out and possibly creating solder bridges 17 between adjacent small solder volume deposits 15a-15d of the same line. This bridging behavior relates to the wetting quality of the solder. In Figure 4, there are only four solder bridges, and very little spread of the small solder volume deposits 15a-15d caused by the reflow. Therefore, inspection of the wetting indicator 12 would yield an estimation of high wetting angles, and low or poor wetting.

In Figure 5, in contrast, forty-eight solder bridges 17 can be counted, and extended spreading out of the small solder volume deposits 15a-15d to the indicator edge to the right, caused by the reflow, is observed. Therefore, inspection of the wetting indicator 12 would yield an estimation of low wetting angles, and excellent solder wetting.

Summarizing the above, by counting the number of solder bridges 17 between the small solder volume deposits 15a-15d after reflow, a quantitative indication of the solder wetting quality is obtained.

In a preferred embodiment shown in Figure 2, the printed circuit board 10 comprises an offset indication pattern 19 indicating the set positions of the small solder volume deposits 15a-15d is provided. More specifically, the offset indication pattern 19 comprises offset indication lines 20a-20d, where each offset indication line 20a-20d corresponds to, and is arranged next to, a line of small solder volume deposits 15a-15d, resulting in an alternating arrangement of small solder volume deposit lines 15a-15d and offset indication lines 20a-20d, as visible in Figure 2. Each offset indication line 20a-20d comprises offset indication spots 21a-21d indicating the set position of the small solder volume deposits 15a-15d along the corresponding line of small solder volume deposits 15a-15d. Preferably, the offset indication lines 20a-20d are made of conductive traces on the substrate 13. In this case, the offset indication spots 21a-21d can be formed by spots of conductive traces, or, as in Figure 2, by voids between conductive traces, which is an inverted scheme. The offset indication spots 21a-21d greatly facilitate the inspection of the small solder volume deposits 15a-15d after curing or baking relative to their set position, which could otherwise be difficult particularly in cases like in Figure 5, where there is little information of the initial position of the small solder volume deposits 15a-15d left in the final pattern. In other words, the offset indication spots 21a-21d show indicate where the gaps between the small solder volume deposits 15a-15d were initially (before the reflow). Thus the number of bridges 17 can be easily counted and judged.

As can be seen for example in Figures 2 and 4, some or all lines of small solder volume deposits 15a-15f have the small solder volume deposits 15a-15f arranged with differently varying distances from each other. For example, in Figure 2, the small solder volume deposits 15b are arranged with slightly larger distances from each other than the small solder volume deposits 15a, the small solder volume deposits 15c are arranged with slightly larger distances from each other than the small solder volume deposits 15b, and the small solder volume deposits 15d are arranged with slightly larger distances from each other than the small solder volume deposits 15c. This feature allows for a more quantitative statement about the soldering quality.

## Claims

1. A printed circuit board (10) comprising a substrate (13) and circuit traces provided on the substrate (13), **characterized in that** the printed circuit board (10) comprises a solder wetting indicator (12), wherein the solder wetting indicator (12) comprises a solder pattern (14) arranged on the substrate (13), wherein the solder pattern (14) comprises small solder volume deposits (15a-15f) arranged along at least one line and having varying distances from each other.

2. The printed circuit board (10) as claimed in claim 1,
wherein the solder pattern (14) comprises small solder volume deposits (15a-15f) arranged along a plurality of lines.

3. The printed circuit board (10) as claimed in claim 2,
wherein the small solder volume deposits (15a-15f) of some or all lines have differently varying distances from each other as compared to the small solder volume deposits of some or all other lines of small solder volume deposits (15a-15f).

4. The printed circuit board (10) as claimed in claim 2 or 3, wherein the lines of small solder volume deposits (15a-15f) are arranged parallel to each other.

5. The printed circuit board (10) as claimed in any one of claims 2 to 4, wherein the solder pattern (14) comprises four lines of small solder volume deposits (15a-15d).

6. The printed circuit board (10) as claimed in any one of the preceding claims, wherein the small solder volume deposits (15a-15e) of the or each line are applied on a corresponding conductive line (16a-16d) provided on the substrate (13).

7. The printed circuit board (10) as claimed in any one of the preceding claims, wherein the solder wetting indicator (12) is arranged in a margin region and/or a waste area of the printed circuit board (10).

8. The printed circuit board (10) as claimed in any one of the preceding claims, wherein the small solder volume deposits (15a-15f) in a line are arranged at least partly with monotonically increasing or decreasing, preferably logarithmically varying, distances.

9. The printed circuit board (10) as claimed in any one of the preceding claims, wherein the solder wetting indicator (12) comprises an offset indication pattern (19) arranged in a positional relationship to the solder pattern (14) and indicating the set positions of the small solder volume deposits (15a-15d) on the substrate (13) before reflow.

10. The printed circuit board (10) as claimed in claim 9,
wherein the offset indication pattern (19) comprises one or more offset indication lines (20a-20d), wherein the or each offset indication line (20a-20d) is arranged in parallel to a corresponding line of small solder volume deposits (15a-15d).

11. The printed circuit board (10) as claimed in claim 9 or 10, wherein the offset indication pattern (19) is made of circuit traces provided on the substrate (13).

12. A method of determining the solder wetting quality of a printed circuit board (10), comprising the steps of:
- providing a printed circuit board (10) with a substrate (13), circuit traces provided on the substrate (13), and a solder wetting indicator (12), wherein the solder wetting indicator (12) comprises a solder pattern (14) arranged on the substrate (13), wherein the solder pattern (14) comprises small solder volume deposits (15a-15f) arranged along at least one line and having varying distances from each other;
- subjecting the printed circuit board (10) to a reflow process;
- counting the number of bridges (17) between adjacent small solder volume deposits (15a-15d) in a line by human inspection or an automatic inspection device; and
- determining the solder wetting quality depending on the number of bridges (17) counted.

13. The method as claimed in claim 12, wherein machine parameters of a machine for producing printed circuit boards (10) are adjusted depending on the determined solder wetting quality.

14. The method as claimed in claim 12 or 13, wherein parameters of a reflow oven for heating printed circuit boards in the production process are adjusted depending on the determined solder wetting quality.
